# EUROPEAN PATENT SPECIFICATION

(11) **EP 2 973 728 B1**
(45) Date of publication and mention of the grant of the patent: **10.07.2019**
(21) Application number: 14710867.4
(22) Date of filing: 14.03.2014
(51) Int. Cl.: H01L 31/0224

(54) **TRANSPARENT ELECTRODE AND SUBSTRATE FOR OPTOELECTRONIC OR PLASMONIC APPLICATIONS COMPRISING SILVER**
TRANSPARENTE ELEKTRODE UND SUBSTRAT FÜR OPTOELEKTRONISCHE ODER PLASMONISCHE ANWENDUNGEN MIT SILBER
ÉLECTRODE TRANSPARENTE ET SUBSTRAT POUR APPLICATIONS OPTOÉLECTRONIQUES OU PLASMONIQUES COMPRENANT DE L'ARGENT

(30) Priority: 14.03.2013 US 201361782786 P
(43) Date of publication of application: 20.01.2016
(73) Proprietor: Fundació Institut de Ciències Fotòniques, 08860 Castelldefels (Barcelona) (ES); Fundació Institució Catalana De Recerca I Estudis Avançats, 08010 Barcelona (ES)
(72) Inventor: PRUNERI, Valerio, E-08860 Castelldefels (Barcelona) (ES); FORMICA, Nadia, E-08860 Castelldefels (Barcelona) (ES); GHOSH, Dhriti, Sundar, E-08860 Castelldefels (Barcelona) (ES)
(74) Representative: Carpintero Lopez, Francisco
(86) International application number: PCT/EP2014/055135
(87) International publication number: WO 2014/140297

(56) References cited:
- WO-A1-2012/007737
- US-A- 5 250 120
- US-A1- 2012 260 983
- US-A1- 2013 025 675
- GUILLÃ CR N C ET AL: "TCO/metal/TCO structures for energy and flexible electronics", THIN SOLID FILMS, vol. 520, no. 1, 31 December 2011 (2011-12-31), pages 1-17, XP028313238, ISSN: 0040-6090, DOI: 10.1016/J.TSF.2011.06.091 [retrieved on 2011-06-30]

## Description

### BACKGROUND OF THE INVENTION

### Field of the Invention

The present invention relates to a metallic structure (transparent electrode or substrate for optoelectronic applications) and a process for its manufacture, such that a silver (Ag) layer of a thickness as small as 10nm, preferably smaller than 6 nm, is achieved on top of a Cu layer, with less rough surface morphology, smaller grain size and lower resistivity and percolation thickness, which improves the performance of optoelectronic devices.

### Description of the Related Art

Transparent electrodes (TEs) have been a very active field of research over the last years because of their importance for electronic and photonic devices, in particular to capacitive displays, organic photovoltaic (OPV) cells and organic light emitting diodes (OLEDs) [Claes G. Granqvist "Transparent conductors as solar energy materials: A panoramic review" Solar Energy Materials & Solar Cells 91, 1529 (2007)]. Indium tin oxide (ITO) is the state-of-the-art material for TEs because of its advantageous trade-off between electrical sheet resistance (Rs) and optical transmission (T) properties. Despite its maturity, ITO suffers from several drawbacks, in particular high cost due to the scarcity of one of its constituents (indium), chemical incompatibility with other layers constituting the devices, such as indium migration into active layers during device operation, lack of mechanical flexibility due to its fragility and thickness and high temperature processing to achieve good electrical performance. These disadvantages have led to the search of new transparent electrode materials, such as carbon nanotubes (CNTs), graphene films, other transparent conducting oxide (TCO), such as AZO and ultrathin metal films. With respect to ITO, AZO is low cost and chemically compatible but suffers from environmental instability. By adding an oxidized ultrathin metal capping layer with a thickness in proximity of their percolation threshold, the environmental stability of AZO thin film is greatly enhanced *[V*. *Pruneri et al., "Transparent electrode based on combination of transparent conductive oxide, metals and oxide",* WO2011101338 (A3*) and* T. L. Chen et al. "Highly stable Al-doped ZnO transparent conductors using an oxidized nickel capping layer at its percolation thickness", Applied Physics Letters 99, 93302 (2011*)*].]. Apart from protection against environmental agents such as humidity and temperature, the oxidized metal capping layer can act as a functionalization layer. With proper choice of metal capping layer, the work function of the TE structure can be tuned depending on target application. The relatively high refractive index of AZO can also be utilized to increase the optical transmittance of thin metal film by overcoming the high reflection of metal and retaining the good electrical behavior of metal [*V. Pruneri et al., "Transparent electrode based on combination of transparent conductive oxide, metals and oxide",* WO2011101338 (A3*)*]. In this sense Ag films have been proposed in combination with transparent oxides, either conductive (e.g. ITO, AZO) or insulating (e.g. ZnO) to form highly transparent and low sheet resistance multilayer transparent electrodes. One example is silver (Ag)/ZnO [D. S. Ghosh et al. "High figure-of-merit Ag/Al:ZnO/Ni nano-thick transparent electrodes for indium-free flexible photovoltaics", Solar Energy Materials and Solar Cells 107, 338 (2012*)*] where average visible transmission of about >75% and sheet resistance of about 6 Ω/sq were achieved with Ag thickness equal to 11 nm. The document US5250120A discloses electrodes for solar cells.

Metal films, when sufficiently thin (10 nm), become transparent to light, and still maintaining good electrical properties. In fact, metal-based transparent electrodes have been demonstrated using metal alloys, thin noble metals, alkaline earth metals protected from oxidation by noble metal layers, multicomponent metals, and single-component ultrathin metal films (UTMFs). Among UTMFs, silver (Ag), nickel (Ni), platinum (Pt) and gold (Au), have been extensively studied since they show high electrical conductivity and relatively high transparency in the visible wavelength range. In this context, UTMFs of two different metals can also be combined to realize TE where one layer act as electrically conductive layer and the other one as a functional capping layer whose choice depends upon the targeted application [*V. Pruneri et al., "Multilayer metallic electrodes for optoelectronics",* US2012260983 *(A1)*]. In particular, Ag has one of the lowest Rs when continuous. There are various reports on using different forms of Ag as a stand-alone layer or in conjunction with other materials, as TEs for various applications [N. Formica et al. "Highly stable Ag-Ni based transparent electrodes on PET substrates for flexible organic solar cells", Solar Energy Materials and Solar Cells 107, 63 (2012*)*].

Besides being used as transparent electrodes, thin Ag films are often employed for innovative applications, including optical switching, optical amplification, optical modulation, plasmonics, microcavities, optical metamaterials, low-emissivity coatings, and many other applications in nanophotonics. This is mainly due to its highest electrical conductivity among all metals, low refractive index (-0.1 in the visible) and low loss at VIS-NIR optical frequencies. However, it is known that Ag films deposited by conventional techniques, including electron beam evaporation, chemical vapor deposition, and sputtering, tend to grow on dielectrics or oxidized surfaces in island-like mode (Volmer-Weber growth mode) and consequently exhibit a rough surface morphology with large grains size and high resistivity, and higher percolation thickness which severely affect the performance of devices. The lowest percolation thickness, i.e. the thickness corresponding to which the metal distributions goes from an island-like to continuous geometry, reported for Ag films is 11 nm deposited by e-beam evaporation on Si/glass substrates [P. Nyga et al. "Mid-IR plasmonics and photo-modification with Ag films" Applied Physics B 93(1), 59 (2008*)*].

Recently, combining template stripping and patterning on silicon substrates, a 30nm thick thermally evaporated Ag film with 0.34nm root mean square (RMS) roughness has been obtained [P. Nagpal et al. "Ultrasmooth Patterned Metals for Plasmonics and Metamaterials" Science, 325, 594 (2009*)*]*.* Further studies have shown that the use of transition metal seed layers can improve the quality of Ag surface morphology, obtaining a semitransparent, homogeneous, spike free, conductive, and adherent layer. Logeeswaran et al. ["Ultrasmooth silver thin films deposited with a germanium nucleation layer" Nanoletters, 9, 178 (2009*)*] also reported a simple method to make ultra- smooth Ag films by employing a thin Ge seed layer with a thickness of 0.5-15nm deposited via e-beam evaporation on SiO2/Si(100) substrates. A dramatic improvement of surface roughness down to about 0.6nm (RMS) was achieved.

There is a need to grow thinner Ag films which are continuous in order to achieve a better trade-off between Rs and T. In particular films of a few nm, more specifically less than 6 nm, can be very advantageous, mostly for applications not requiring very low Rs, such as is the case of capacitive devices, including displays. There is also the need to optimize their optical properties, in particular with respect to T. Lower cost TEs that are mechanically flexible and environmentally stable to replace ITO for optoelectronic applications (in particular for devices requiring relatively low electrical current, such is the case of tactile displays for smartphone and tablets) would then be possible.

### SUMMARY OF THE INVENTION

Accordingly, it is an object of the present invention to solve the above-described problems and produce a transparent electrode or substrate with an atomically-smooth (that is, its roughness is less than 1nm) and electrically continuous Ag film with a thickness of ≤ 10nm, preferably ≤ 6 nm. and having greater electrical conductivity in comparison to monolayer Ag films. The Ag is formed on top of a Cu seed layer of less than 2nm. The Ag can optionally be capped with an appropriate refractive index layer, e.g. thin AZO layer, which acts as an anti-reflective medium for the highly reflecting Ag layer beneath it. Also an additional undercoat layer with an appropriate index of refraction can be interposed between the substrate and the Cu seeded Ag film to reduce even further the reflection and correspondingly increase T. The undercoat layer can also favor the deposition of the Cu seeded Ag structure and protect it from detrimental interaction with the substrate, for example by preventing moisture or oxygen to reach the thin metals when the substrate is not impermeable to water or releases oxygen. Finally an additional functional layer can be added on the top of the Ag or antireflective layer, in any of the previous embodiments, to confer specific surface properties. This functional layer can be UTMF, oxidized UTMF, graphene, etc.

### BRIEF DESCRIPTION OF THE DRAWINGS

To complete the description and in order to provide for a better understanding of the invention, a set of drawings is provided. Said drawings illustrate a preferred embodiment of the invention, which should not be interpreted as restricting the scope of the invention, but just as an example of how the invention can be embodied. The drawings comprise the following figures:

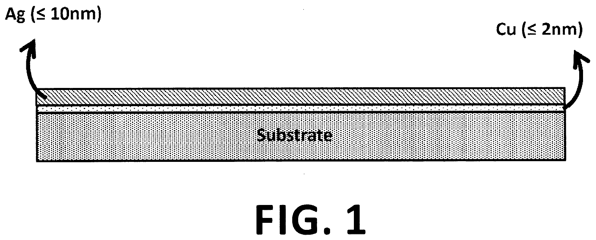

Fig.1 shows the invention in its simplest form.

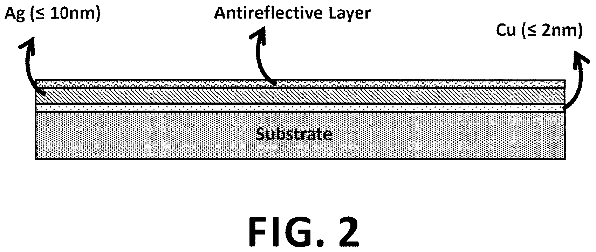

Fig.2 shows the invention further comprising an antireflective layer on top of the Ag layer.

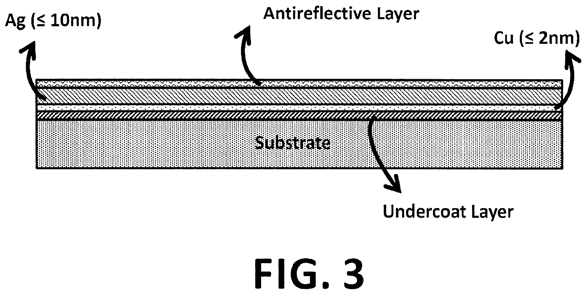

Fig.3 is the same structure with a further undercoat layer between the Cu and substrate.

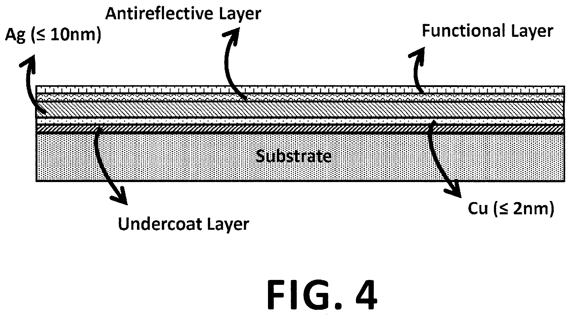

Fig.4 shows the invention provided with additional functional layer on top.
Fig.5 is a three dimensional AFM images of Ag 6nm (left), and 1nm Cu/6nm Ag (right).
Fig.6 is a graph of the variation of RMS roughness for an electrode according to the invention with a Ag 6nm film.
Fig.7 shows a comparison between the reflectance spectra of ultrathin Ag layers deposited with Cu 1nm layer (continuous lines) and without seed layer (dashed lines).
Fig.8 is a comparison of electrical resistivity variation for Ag films with and without a Cu seed layer.
Fig.9 shows the optical transmittance (including substrate) of Cu 1nm seeded Ag 4nm film with and without AZO capping layer.
Fig.10 illustrates the optical transmittance (including substrate) of Cu 1nm seeded Ag 5.5 nm film with AZO capping and/or undercoat layer.
Fig.11 shows the variation of electrical sheet resistance as a function of bending cycles.

### DESCRIPTION OF THE PREFERRED EMBODIMENTS

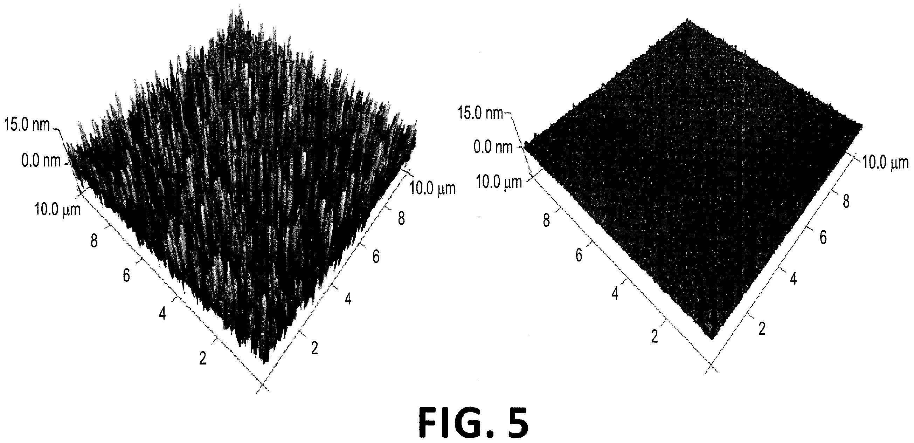

Samples consisting of 6nm Ag films with and without Cu seed layer of 1nm thickness were prepared under the same deposition conditions. The films were fabricated on optically polished 1mm UV grade fused silica substrates by using magnetron sputtering system (ATC Orion 8 HV) in Ar atmosphere. The Cu and Ag layers were deposited sequentially without breaking the deposition chamber vacuum by DC sputtering from Cu and Ag targets of 3 inch diameter. The main chamber was typically evacuated to a base pressure of 10⁻⁷-10⁻⁸ Torr and deposition was performed under the following conditions: DC power 100 W, a pure Ar working pressure of 2x10⁻³ Torr and the target - substrate separation was 300 mm. The substrate is continuously rotated for the uniformity of film deposition. The deposition rates, which are 2.56 Å/s for Ag and 1.5 Å/s for Cu, were determined using a MCM-160 quartz crystal and cross-sectional SEM measurements. Prior to the deposition, the substrates were ultrasonically cleaned with acetone and ethanol for 10 min, dried under flowing nitrogen, heated in oven at 100 °C for 30 min. and finally transferred to the deposition chamber where they underwent a 15 min argon plasma cleaning treatment at 40 W RF power and a pressure of 8x10⁻³ Torr. The argon plasma treatment activates the substrate surface and thus helps in the better adhesion between the substrate and the subsequent deposited layers. The depositions were performed at room temperature (22°C) although a marginal increase of temperature (<4°C) was observed due to the sputtering process. The substrates used were characterized by very low RMS surface roughness <5 Å. Fig. 5 shows the 3-D AFM images for the following ultra-thin film structures: 6nm Ag and 1nm Cu/6nm Ag samples, which are characterized by a RMS surface roughness of 4.74nm and 0.487nm, respectively. The scanning area was 10µm x 10µm and the maximum z-scale value for all the films is 25nm. As can be seen, the use of Cu as a seed layer leads to an exceptionally smooth Ag films with a RMS roughness less than 0.5nm, thus reducing the roughness by a factor of 10; suggesting a layer-by-layer growth mode.

**Table 1**

| | RMS roughness (nm) | Peak-to-Valley Roughness (nm) | Image Surface area difference (%) | Resistivity (10⁻⁷ Ωm) |
|---|---|---|---|---|
| Ag 6nm | 4.74 | 39.5 | 0.987 | 2.9 |
| 1nm Cu/6nm Ag | 0.487 | 7.21 | 0.0144 | 0.80 |

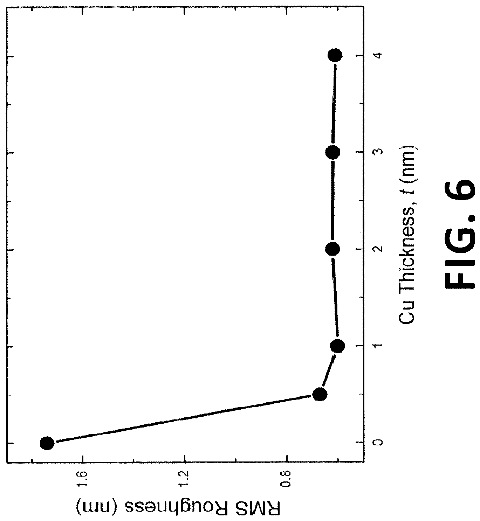

Table 1 summarizes the different surface morphology parameters for the deposited films. The 3^{rd} column quantifies the percentage increase of surface area of the real surface when compared to a flat surface of the same dimensions. A film with zero image surface area difference represents a perfect smooth sample. The 1nm Cu seed layer forms an energetically favorable nucleation sites for the incoming Ag atoms, thus leading to smoother films. Due to its relatively high surface energy, the Cu seed layer produces a favorable wetting effect for the subsequent Ag growth. Consequently, Ag film deposited atop of a Cu seed layer tends to be smoother and exhibit a lower percolation threshold than Ag film directly atop of SiO₂, as it has been evidenced in our experiments. Fig. 6 shows the RMS roughness as a function of Cu seed layer thickness for a constant Ag thickness of 6nm. An improvement in the RMS surface roughness from 4.74nm to 0.7nm was obtained for the first 0.5nm of Cu deposited. For seed layer thicknesses greater than 1nm the roughness remains the same at about 0.6nm. These results demonstrate the potential of the Cu seed layer for fabricating smooth Ag films.

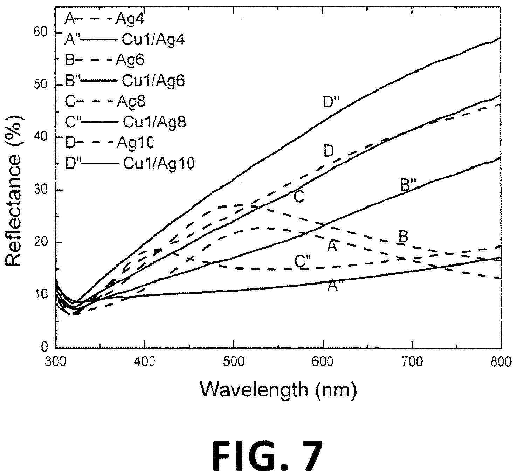

Optical reflectance spectra of thin films are indicative of the wetting condition and mode of growth. We investigated the influence of a Cu wetting layer on Ag growth through the reflectance spectrum in the 300-800nm range. Fig. 7 shows the reflectance spectra for Ag films of different thickness with and without Cu seed layer. As can be seen, the films without seed layer are characterized by a different trend with respect to the other set of samples having the additional seed layer. The peaks in the reflection spectra shift to shorter wavelengths with increasing thickness; observed for films up to 8nm of Ag. This optical behavior is caused by a localized plasmon resonance in the metal particles. The localized plasmon resonance in the earlier stages of film growth is induced by collective oscillations of conduction electrons, which are confined within the Ag grain. This plasmon resonant character disappears when the nano-structuring of the Ag film disappears. This difference between the curves is due to changes in the morphology of the metal and indicates a discontinuous and a continuous Ag layer without and with Cu seed layer respectively. From these measurements it emerges that the Ag film 4nm thick is already continuous on a Cu seed layer, while without the Cu seed layer a continuous film occurs at a thickness around 10nm.

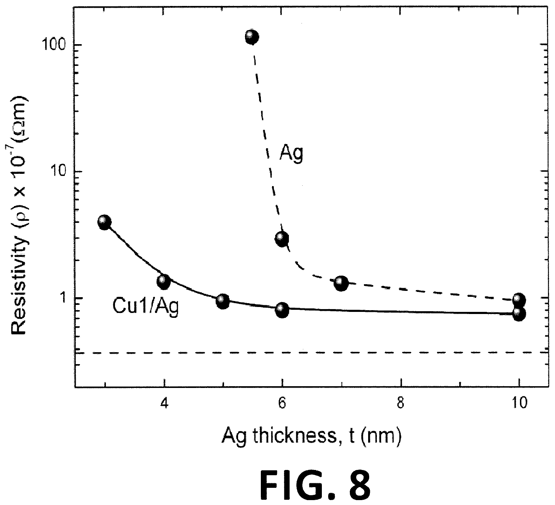

Thin Ag films with a nominal thickness between 3 and 10nm were also sputtered with and without 1nm Cu seed layer, and electrical measurements were carried out. As it is shown in Fig. 8, when the nominal thickness of the single layer Ag film reaches a certain value, 6nm, a sharp drop of the electrical resistivity by several orders of magnitude can be observed, indicating the coalescence of islands. Instead, when using a very thin seed layer, 1nm Cu layer, coalescence of Ag occurs earlier compared to deposition without this material. The results in demonstrate that Ag film on Cu seed layer exhibits a lower percolation threshold than a pure Ag film on silica substrates. By employing the Cu seed layer continuous Cu films with thickness equal to 3-4nm were achieved which is much lower than the reported 11nm percolation threshold of e-beam evaporated Ag films on Si/glass substrates [P. Nyga et al. "Mid-IR plasmonics and photo-modification with Ag films" Applied Physics B 93(1), 59 (2008*)*]*.* The dashed flat line at the bottom represents the resistivity of bulk Ag film of about 300 nm thickness deposited using the same sputtering process.

Another advantage associated with the seed layer assisted growth of Ag films is that unlike the pure Ag film the Cu/Ag films it offers much more resistance to corrosion in ambient conditions. This is due to the fact that rougher Ag films present larger surface area to the O₂/H₂O present in the atmosphere leading to their oxidation within few hours after their preparation while the smoother Cu/Ag films remain stable even after 4 months of fabrication. For the pure Ag film, the color changes from grey to reddish-brown and it also shows infinite electrical resistivity which clearly indicates the oxidation of the sample. On the contrary, the Cu seeded Ag film showed the same electrical behavior over 4 month's period of time.

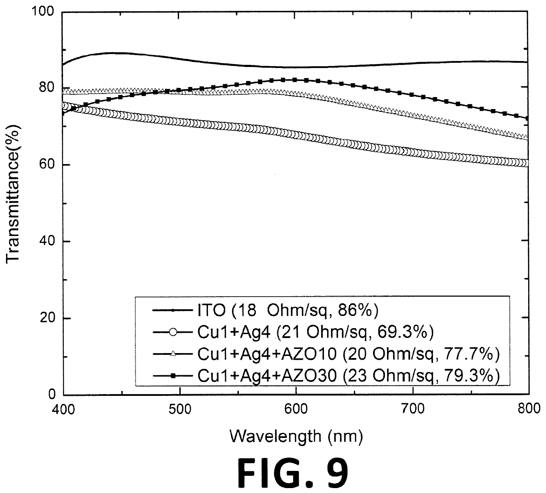

Fig. 9 shows the optical transmittance (including the substrate) of Cu 1nm seeded Ag 4nm film with and without AZO capping layer. The average transmission values reported in the figure inset are values averaged over the 400 to 700 nm range. The inset also shows the values of electrical sheet resistance. For comparison the optical transmittance and sheet resistance of commercially available ITO on a similar substrate are also shown. The AZO capping layer was deposited in the same ATC Orion 8 HV sputtering machine and deposited just after the metal deposition without breaking the vacuum. The AZO sputtering is performed in a mixture of argon and oxygen atmosphere in the ration of 18:2 sccm and 150 W RF power. The sputtering target used is Zinc Oxide target 3 at % doped Al. The rate of deposition of AZO is determined to be 0.33 Å/s. The average transmission values reported in the figure inset are values averaged over the 400 to 700 nm range. For comparison the optical transmittance and sheet resistance of commercially available ITO on a similar substrate are also shown. The electrical sheet resistance values for each film are also shown in the inset. The AZO capping layer helps to suppress the reflection of Cu 1nm seeded Ag 4nm film. As mentioned previously, apart from anti-reflection properties, the AZO capping layer also helps to protect the underlying metallic layer from environmental agents such as humidity and temperature. The optical spectra for AZO capped seeded Ag films exhibits a much flatter behavior and is well suited for most of the application. Instead of capping with AZO, one can use ITO.

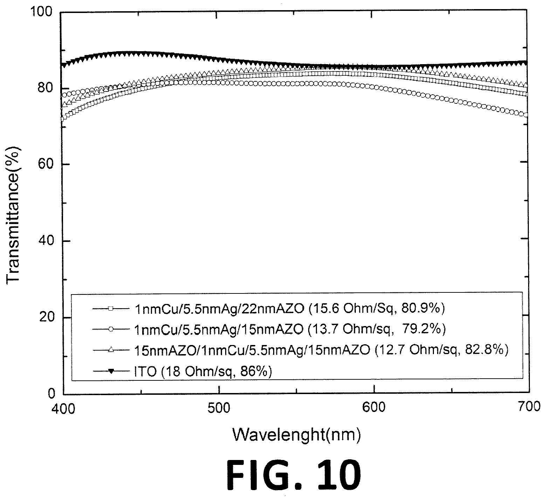

In another embodiment one can add an undercoat layer between the Cu seeded Ag structure and the substrate, for example AZO or other appropriate refractive index materials. Besides improving the optical transmission the undercoat layer can also be used to increase the adhesion of the Cu seeded Ag structure or its stability, for example when the undercoat layer is impermeable to unwanted chemical elements (e.g. oxygen, water, etc...) that can penetrate the substrate material. Fig. 10 shows the optical transmittance of TE structures with a Cu 1 nm seeded Ag layer of 5.5 nm thicknesses and also incorporating an undercoat layer of AZO in between the Cu seeded Ag structure and the glass substrate. The average transmission values reported in the figure inset are values averaged over the 400 to 700 nm range. The inset also shows the values of electrical sheet resistance. For comparison the optical transmittance and sheet resistance of commercially available ITO on a similar substrate are also shown.

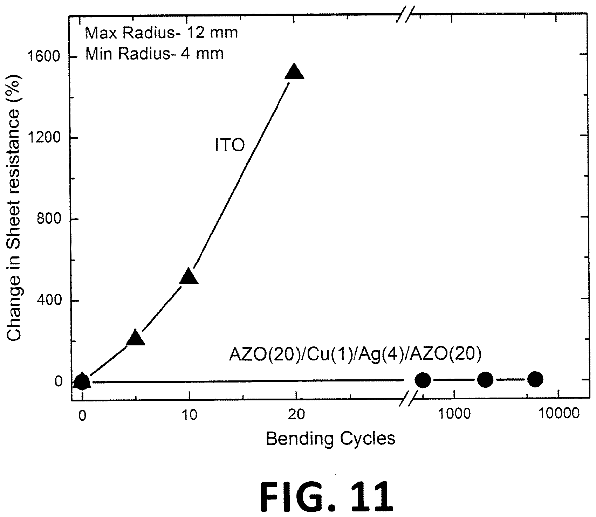

Fig. 11 shows the mechanical flexibility of the proposed TE structures under bending. Both ITO and AZO 20nm/Cu 1nm/Ag 4nm/AZO 20nm were deposited on flexible PET substrate.

For this purpose the following multilayer structure was deposited on a PET substrate: AZO 20nm, followed by Cu 1nm seeded Ag 4nm, and capped by AZO 20 nm. The maximum and minimum radii of curvature for each bending are 12 and 4 nm respectively.

The proposed TE structures can further be capped with ultrathin metal layer such as Ni, Pt, Au, Ti, In, Sn and Al or mixtures which further can be oxidized. The choice of the additional ultrathin metal capping layer depends upon the target applications. For example, for applications where TE with high work function is required the proposed structure can be capped with thin Ni or Au layer whereas Ti or Al can be deposited where low work function TE is desired. Some of these metals can also be oxidized to improve the work function while reducing the reflection [Valerio Pruneri et al. US2011114226 (A1*)].* Also other functional layers could be used for changing surface properties (work function, chemical reactivity, etc...) as well as protection of the underneath TE structure. These include graphene and poly(3,4-ethylenedioxythiophene) poly(styrenesulfonate)(PEDOT:PSS). In particular the resulting TE is very suitable for flexible substrates and display applications, being highly competitive to other materials, including ITO, AZO, Ag nanowires and graphene. The optical transmission can be larger than 80% (average visible including the substrate) and electrical sheet resistance lower than 20 Ω/square, while the structure is mechanically flexible and environmentally stable.

With respect to the prior art, the invention allows to:
- achieve the smallest thickness (hence highest transparency) reported so far for a Ag layer still continuous, i.e. electrically conductive;
- the smoothest, lowest roughness, Ag film ever reported at these thicknesses;
- the Cu seeded Ag structure can already be an effective TE, which shows also larger stability, for example against oxidation, with respect to the unseeded layer.
- in combination with an optional antireflective layer, e.g. AZO or ITO, achieve a TE of high quality factor, i.e. optimal optical transmission (T) and electrical sheet resistance (Rs) trade-off. The electro-optical performances are comparable to widely used ITO and AZO only based TEs, in particular Rs value lower than 20 Ω/□ and average visible T larger than 80%.
- the electro-optical performance can be enhanced further by adding an additional undercoat layer, e.g. AZO, between the Cu seeded Ag structure and the substrate;
- an additional functional layer, for example another ultrathin metal film, graphene, or poly(3,4-ethylenedioxythiophene) poly(styrenesulfonate) (PEDOT:PSS), can be added to the above TE structure to confer functional properties, such as high or low work function, impermeability, improved thermal and chemical stability.
- the proposed TE geometries are mechanically flexible, this feature being essential for low cost roll-to-roll fabrication using bendable substrate, such as polymeric substrates, thin metals and thin glass;
- the proposed TE geometries are stable, i.e. T and Rs do not change, in temperature and damp heat (temperature and humidity) conditions;

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

## Claims

1. A transparent electrode comprising a transparent substrate and at least one double layer on top of the substrate, the double layer consisting of a seed Cu layer with a thickness of 2nm or less and a continuous Ag layer on top and in contact with the Cu seed layer with a thickness of 10nm or less.

2. The transparent electrode of claim 1 where the Cu layer has a thickness of 1nm or less and de Ag layer has a thickness of 6nm or less.

3. The transparent electrode of claim 1 where the substrate is a semiconductor, organic or dielectric material, including glass, silicon, polyethylene terephthalate, and polyethylene naphthalate.

4. Transparent electrode of claim 1 where the substrate is a mechanically flexible material, including glass with a thickness of 0.3 mm or less.

5. The transparent electrode of claim 1 with at least one of the following additional layers:
- additional antireflective layer on top of the Ag layer,
- an undercoat layer between the Cu layer and the substrate with adhesion, protective, antireflective or a combination of any of these properties,
- functional top layer with work function matching, protective or a combination of any of these properties.

6. The transparent electrode of claim 5 where the antireflective layer is Al doped ZnO (AZO) or Indium tin oxide (ITO).

7. The transparent electrode of claim 5 where the undercoat and functional layers are an ultrathin metal film of thickness less or equal 5nm, preferably less or equal 2 nm, comprising the metals Ni, Al, Ti, Pt, Sn, In, an oxide of Ti, Si, Zn, Al, Sn, In or mixture of these elements, of thickness less or equal 50nm, preferably less or equal 30nm, an oxidized ultrathin metal film, including oxidized Ni, oxidized Al, oxidized Ti, oxidized Pt, graphene and poly(3,4-ethylenedioxythiophene) poly(styrenesulfonate)(PEDOT:PSS).

8. The transparent electrode of claim 7 where the undercoat and functional layers are an ultrathin metal film or oxidized ultrathin metal of a thickness of less than 2nm.

9. The transparent electrode of claim 1 wherein the Cu layer has a thickness between 0.5 and 1nm, the Ag layer has a thickness between 3 and 6 nm and wherein the electrode further comprises an AZO or ITO layer of a thickness between 10 and 30nm on top of the Ag layer.

10. A substrate for optoelectronic or plasmonic applications comprising a transparent electrode according to claims 1 to 9.

11. The substrate of claim 10 where the Cu layer has a thickness of 1nm or less and de Ag layer has a thickness of 6nm or less.

12. The substrate of claim 10 with at least one of the following additional layers:
- additional antireflective layer on top of the Ag layer,
- an undercoat layer between the Cu layer and the substrate with adhesion, protective, antireflective or a combination of any of these properties,
- functional top layer with work function matching, protective or a combination of any of these properties.

13. The substrate of claim 12 where the undercoat and functional layers are an ultrathin metal film of thickness less or equal 5nm, preferably less or equal 2 nm, comprising the metals Ni, Al, Ti, Pt, In, Sn, an oxide of Ti, Si, Zn, Al, In, Sn or mixture of these elements, of thickness less or equal 50nm, preferably less or equal 30nm, an oxidized ultrathin metal film, including oxidized Ni, oxidized Al, oxidized Ti, oxidized Pt, graphene and poly(3,4-ethylenedioxythiophene) poly(styrenesulfonate)(PEDOT:PSS).

14. The substrate of claim 12 where the undercoat and functional layers are an ultrathin metal film or oxidized ultrathin metal of a thickness of less than 2nm.

15. The substrate of claim 12 wherein the Cu layer has a thickness between 0.5 and 1nm, the Ag layer has a thickness between 3 and 6 nm and further comprising an AZO or ITO layer of a thickness between 10 and 30nm on top of the Ag layer.

## Patentansprüche

1. Transparente Elektrode, umfassend ein transparentes Substrat und zumindest eine Doppelschicht auf dem Substrat, wobei die Doppelschicht aus einer Cu-Keimschicht mit einer Dicke von 2 nm oder weniger und einer durchgehenden Ag-Schicht auf und in Kontakt mit der Cu-Keimschicht mit einer Dicke von 10 nm oder weniger besteht.

2. Transparente Elektrode nach Anspruch 1, wobei die Cu-Schicht eine Dicke von 1 nm oder weniger aufweist und die Ag-Schicht eine Dicke von 6 nm oder weniger aufweist.

3. Transparente Elektrode nach Anspruch 1, wobei das Substrat ein Halbleiter, ein organisches oder dielektrisches Material, umfassend Glas, Silicium, Polyethylenterephthalat und Polyethylennaphthalat, ist.

4. Transparente Elektrode nach Anspruch 1, wobei das Substrat ein mechanisch flexibles Material, umfassend Glas mit einer Dicke von 0,3 mm oder weniger, ist.

5. Transparente Elektrode nach Anspruch 1 mit mindestens einer der folgenden zusätzlichen Schichten:
- einer zusätzlichen Antireflexionsschicht auf der Ag-Schicht,
- einer Untergrundschicht zwischen der Cu-Schicht und dem Substrat mit Adhäsion, schützend, antireflektierend oder einer Kombination von jeder dieser Eigenschaften,
- einer funktionellen oberen Schicht mit Anpassung der Austrittsarbeit, schützend oder einer Kombination von jeder dieser Eigenschaften.

6. Transparente Elektrode nach Anspruch 5, wobei die Antireflexionsschicht mit Al dotiertes ZnO (AZO) oder Indium-Zinn-Oxid (ITO) ist.

7. Transparente Elektrode nach Anspruch 5, wobei die Untergrundschicht und die funktionelle Schicht sind: ein ultradünner Metallfilm von einer Dicke kleiner oder gleich 5 nm, vorzugsweise kleiner oder gleich 2 nm, der die Metalle Ni, Al, Ti, Pt, Sn, In umfasst, ein Oxid von Ti, Si, Zn, Al, Sn, In oder einem Gemisch dieser Elemente, von einer Dicke kleiner oder gleich 50 nm, vorzugsweise kleiner oder gleich 30 nm, ein ultradünner oxidierter Metallfilm, der oxidiertes Ni, oxidiertes Al, oxidiertes Ti, oxidiertes Pt umfasst, Graphen und Poly(3,4-ethylendioxythiophen)-Poly(styrolsulfonat) (PEDOT:PSS).

8. Transparente Elektrode nach Anspruch 7, wobei die Untergrundschicht und die funktionelle Schicht ein ultradünner Metallfilm oder ein ultradünner oxidierter Metallfilm von einer Dicke von weniger als 2 nm sind.

9. Transparente Elektrode nach Anspruch 1, wobei die Cu-Schicht eine Dicke zwischen 0,5 und 1 nm aufweist, die Ag-Schicht eine Dicke zwischen 3 und 6 nm aufweist und wobei die Elektrode weiterhin eine AZO-Schicht oder ITO-Schicht von einer Dicke zwischen 10 und 30 nm auf der Ag-Schicht umfasst.

10. Substrat für optoelektronische oder plasmonische Anwendungen, umfassend eine transparente Elektrode nach den Ansprüchen 1 bis 9.

11. Substrat nach Anspruch 10, wobei die Cu-Schicht eine Dicke von 1 nm oder weniger aufweist und die Ag-Schicht eine Dicke von 6 nm oder weniger aufweist.

12. Substrat nach Anspruch 10 mit mindestens einer der folgenden zusätzlichen Schichten:
- einer zusätzlichen Antireflexionsschicht auf der Ag-Schicht,
- einer Untergrundschicht zwischen der Cu-Schicht und dem Substrat mit Adhäsion, schützend, antireflektierend oder einer Kombination von jeder dieser Eigenschaften,
- einer funktionellen oberen Schicht mit Anpassung der Austrittsarbeit, schützend oder einer Kombination von jeder dieser Eigenschaften.

13. Substrat nach Anspruch 12, wobei die Untergrundschicht und die funktionelle Schicht sind: ein ultradünner Metallfilm von einer Dicke kleiner oder gleich 5 nm, vorzugsweise kleiner oder gleich 2 nm, der die Metalle Ni, Al, Ti, Pt, In, Sn umfasst, ein Oxid von Ti, Si, Zn, Al, In, Sn oder einem Gemisch dieser Elemente, von einer Dicke kleiner oder gleich 50 nm, vorzugsweise kleiner oder gleich 30 nm, ein ultradünner oxidierter Metallfilm, der oxidiertes Ni, oxidiertes Al, oxidiertes Ti, oxidiertes Pt umfasst, Graphen und Poly(3,4-ethylendioxythiophen)-Poly(styrolsulfonat) (PEDOT:PSS).

14. Substrat nach Anspruch 12, wobei die Untergrundschicht und die funktionelle Schicht ein ultradünner Metallfilm oder ein ultradünner oxidierter Metallfilm von einer Dicke von weniger als 2 nm sind.

15. Substrat nach Anspruch 12, wobei die Cu-Schicht eine Dicke zwischen 0,5 und 1 nm aufweist, die Ag-Schicht eine Dicke zwischen 3 und 6 nm aufweist, und weiterhin umfassend eine AZO-Schicht oder ITO-Schicht von einer Dicke zwischen 10 und 30 nm auf der Ag-Schicht.

## Revendications

1. Électrode transparente comprenant un substrat transparent et au moins une couche double sur le dessus du substrat, la couche double consistant en une couche de germination en Cu avec une épaisseur de 2 nm ou moins et une couche d'Ag continue sur le dessus et en contact avec la couche de germination en Cu avec une épaisseur de 10 nm ou moins.

2. Électrode transparente selon la revendication 1 où la couche en Cu a une épaisseur de 1 nm ou moins et la couche d'Ag a une épaisseur de 6 nm ou moins.

3. Électrode transparente selon la revendication 1 où le substrat est une matière organique ou diélectrique semi-conductrice, incluant du verre, du silicium, du polytéréphtalate d'éthylène, et du polynaphtalate d'éthylène.

4. Électrode transparente selon la revendication 1 où le substrat est une matière mécaniquement souple, incluant du verre avec une épaisseur de 0,3 mm ou moins.

5. Électrode transparente selon la revendication 1 avec au moins une des couches additionnelles suivantes :
- couche additionnelle antiréfléchissante sur le dessus de la couche d'Ag,
- une couche de fond entre la couche en Cu et le substrat avec une propriété d'adhérence, de protection, d'antiréflexion ou une combinaison de n'importe lesquelles de ces propriétés,
- couche de dessus fonctionnelle avec une propriété d'adaptation de travail d'extraction, de protection ou une combinaison de n'importe lesquelles de ces propriétés.

6. Électrode transparente selon la revendication 5 où la couche antiréfléchissante est du ZnO dopé à l'Al (AZO) ou de l'oxyde d'étain dopé à l'indium (ITO).

7. Électrode transparente selon la revendication 5 où les couches de fond et fonctionnelle sont un film métallique ultra-mince d'épaisseur inférieure ou égale à 5 nm, de préférence inférieure ou égale à 2 nm, comprenant les métaux Ni, Al, Ti, Pt, Sn, In, un oxyde de Ti, Si, Zn, Al, Sn, In ou un mélange de ces éléments, d'épaisseur inférieure ou égale à 50 nm, de préférence inférieure ou égale à 30 nm, un film métallique ultra-mince oxydé, incluant du Ni oxydé, de l'Al oxydé, du Ti oxydé, du Pt oxydé, du graphène et du poly(3,4-éthylènedioxythiophène) poly(styrènesulfonate) (PEDOT:PSS).

8. Électrode transparente selon la revendication 7 où les couches de fond et fonctionnelle sont un film métallique ultra-mince ou un métal ultra-mince oxydé d'une épaisseur inférieure à 2 nm.

9. Électrode transparente selon la revendication 1, dans laquelle la couche en Cu a une épaisseur entre 0,5 et 1 nm, la couche d'Ag a une épaisseur entre 3 et 6 nm et dans laquelle l'électrode comprend en outre une couche d'AZO ou ITO d'une épaisseur entre 10 et 30 nm sur le dessus de la couche d'Ag.

10. Substrat pour applications optroniques ou plasmoniques comprenant une électrode transparente selon les revendications 1 à 9.

11. Substrat selon la revendication 10 où la couche en Cu a une épaisseur de 1 nm ou moins et la couche d'Ag a une épaisseur de 6 nm ou moins.

12. Substrat selon la revendication 10 avec au moins une des couches additionnelles suivantes :
- couche additionnelle antiréfléchissante sur le dessus de la couche d'Ag,
- couche de fond entre la couche en Cu et le substrat avec une propriété d'adhérence, de protection, d'antiréflexion ou une combinaison de n'importe lesquelles de ces propriétés,
- couche de dessus fonctionnelle avec une propriété d'adaptation de travail d'extraction, de protection ou une combinaison de n'importe lesquelles de ces propriétés.

13. Substrat selon la revendication 12 où les couches de fond et fonctionnelle sont un film métallique ultra-mince d'épaisseur inférieure ou égale à 5 nm, de préférence inférieure ou égale à 2 nm, comprenant les métaux Ni, Al, Ti, Pt, In, Sn, un oxyde de Ti, Si, Zn, Al, In, Sn ou un mélange de ces éléments, d'épaisseur inférieure ou égale à 50 nm, de préférence inférieure ou égale à 30 nm, un film métallique ultra-mince oxydé, incluant du Ni oxydé, de l'Al oxydé, du Ti oxydé, du Pt oxydé, du graphène et du poly(3,4-éthylènedioxythiophène) poly(styrènesulfonate) (PEDOT:PSS).

14. Substrat selon la revendication 12 où les couches de fond et fonctionnelle sont un film métallique ultra-mince ou un métal ultra-mince oxydé d'une épaisseur inférieure à 2 nm.

15. Substrat selon la revendication 12 dans lequel la couche de Cu a une épaisseur entre 0,5 et 1 nm, la couche d'Ag a une épaisseur entre 3 et 6 nm et comprenant en outre une couche d'AZO ou ITO d'une épaisseur entre 10 et 30 nm sur le dessus de la couche d'Ag.
